Europäisches Patentamt

European Patent Office

Office européen des brevets

(19)

(11) **EP 1 271 248 A1**

(12) **EUROPEAN PATENT APPLICATION**

(43) Date of publication:
**02.01.2003 Bulletin 2003/01**

(51) Int Cl.$^7$: **G03F 7/20**

(21) Application number: **02254550.3**

(22) Date of filing: **28.06.2002**

(84) Designated Contracting States:
**AT BE CH CY DE DK ES FI FR GB GR IE IT LI LU
MC NL PT SE TR**
Designated Extension States:
**AL LT LV MK RO SI**

(30) Priority: **29.06.2001 EP 01202520**

(71) Applicant: **ASML Netherlands B.V.
5503 LA Veldhoven (NL)**

(72) Inventors:
- **Butler, Hans
  5685 AC Best (NL)**
- **Verbeek, Thijs Rein
  3011 JL Rotterdam (NL)**

(74) Representative: **Leeming, John Gerard
J.A. Kemp & Co.,
14 South Square,
Gray's Inn
London WC1R 5JJ (GB)**

(54) **Lithographic apparatus**

(57)  The invention relates to a lithographic apparatus comprising:

- a radiation system for supplying a projection beam of radiation;
- a support structure for supporting patterning means, the patterning means serving to pattern the projection beam according to a desired pattern;
- a substrate table for holding a substrate; and
- a projection system mounted on a main plate for projecting the patterned beam onto a target portion of the substrate.

The projection system is constantly moving vibrationally resulting in fading of the projected features on the target portion of the substrate. The present invention aims to reduce such undesirable vibrational movements. This is achieved by measuring the vibrational movements with a detection means. The detection means generates a movement signal to which a control means is responsive and the control means in turn generates a control signal. A preferred algorithm used to generate the control signal is based on a method referred to as H infinity. The control signal is passed on to actuation means. The actuation means compensate the vibrational movement of the projection lens, thereby improving the imaging accuracy of the projected features on the substrate.

Fig. 20

**EP 1 271 248 A1**

## Description

The present invention relates to a lithographic projection apparatus comprising:

- a radiation system for supplying a projection beam of radiation;
- a support structure for supporting patterning means, the patterning means serving to pattern the projection beam according to a desired pattern;
- a substrate table for holding a substrate; and
- a projection system mounted on a main plate for projecting the patterned beam onto a target portion of the substrate.

The term "patterning means" as here employed should be broadly interpreted as referring to means that can be used to endow an incoming radiation beam with a patterned cross-section, corresponding to a pattern that is to be created in a target portion of the substrate; the term "light valve" can also be used in this context. Generally, the said pattern will correspond to a particular functional layer in a device being created in the target portion, such as an integrated circuit or other device (see below). Examples of such patterning means include:

- A mask. The concept of a mask is well known in lithography, and it includes mask types such as binary, alternating phase-shift, and attenuated phase-shift, as well as various hybrid mask types. Placement of such a mask in the radiation beam causes selective transmission (in the case of a transmissive mask) or reflection (in the case of a reflective mask) of the radiation impinging on the mask, according to the pattern on the mask. In the case of a mask, the support structure will generally be a mask table, which ensures that the mask can be held at a desired position in the incoming radiation beam, and that it can be moved relative to the beam if so desired.
- A programmable mirror array. An example of such a device is a matrix-addressable surface having a viscoelastic control layer and a reflective surface. The basic principle behind such an apparatus is that (for example) addressed areas of the reflective surface reflect incident light as diffracted light, whereas unaddressed areas reflect incident light as undiffracted light. Using an appropriate filter, the said undiffracted light can be filtered out of the reflected beam, leaving only the diffracted light behind; in this manner, the beam becomes patterned according to the addressing pattern of the matrix-adressable surface. The required matrix addressing can be performed using suitable electronic means. More information on such mirror arrays can be gleaned, for example, from US 5,296,891 and US 5,523,193, which are incorporated herein by reference. In the case of a programmable mirror array, the said support structure may be embodied as a frame or table, for example, which may be fixed or movable as required.
- A programmable LCD array. An example of such a construction is given in US 5,229,872, which is incorporated herein by reference. As above, the support structure in this case may be embodied as a frame or table, for example, which may be fixed or movable as required.

For purposes of simplicity, the rest of this text may, at certain locations, specifically direct itself to examples involving a mask and mask table; however, the general principles discussed in such instances should be seen in the broader context of the patterning means as hereabove set forth.

Lithographic projection apparatus can be used, for example, in the manufacture of integrated circuits (ICs). In such a case, the patterning means may generate a circuit pattern corresponding to an individual layer of the IC, and this pattern can be imaged onto a target portion (e.g. comprising one or more dies) on a substrate (silicon wafer) that has been coated with a layer of radiation-sensitive material (resist). In general, a single wafer will contain a whole network of adjacent target portions that are successively irradiated via the projection system, one at a time. In current apparatus, employing patterning by a mask on a mask table, a distinction can be made between two different types of machine. In one type of lithographic projection apparatus, each target portion is irradiated by exposing the entire mask pattern onto the target portion in one go; such an apparatus is commonly referred to as a wafer stepper. In an alternative apparatus — commonly referred to as a step-and-scan apparatus — each target portion is irradiated by progressively scanning the mask pattern under the projection beam in a given reference direction (the "scanning" direction) while synchronously scanning the substrate table parallel or anti-parallel to this direction; since, in general, the projection system will have a magnification factor M (generally < 1), the speed V at which the substrate table is scanned will be a factor M times that at which the mask table is scanned. More information with regard to lithographic devices as here described can be gleaned, for example, from US 6,046,792, incorporated herein by reference.

In a manufacturing process using a lithographic projection apparatus, a pattern (e.g. in a mask) is imaged onto a substrate that is at least partially covered by a layer of radiation-sensitive material (resist). Prior to this imaging step, the substrate may undergo various procedures, such as priming, resist coating and a soft bake. After exposure, the substrate may be subjected to other procedures, such as a post-exposure bake (PEB), development, a hard bake and measurement/inspection of the imaged features. This array of procedures is used as a basis to pattern an individual layer of a device, e.g. an IC. Such a patterned layer may then undergo various processes such as etching, ion-implantation (doping), metallization, oxidation, chemo-mechanical polishing, etc., all intended to finish off an individual layer. If several layers are required, then the whole procedure, or a variant thereof, will have to be repeated for each new layer. Eventually, an array of devices will be present on the substrate (wafer). These devices are then separated from one another by a technique such as dicing or sawing, whence the individual devices can be mounted on a carrier, connected to pins, etc. Further information regarding such processes can be obtained, for example, from the book "Microchip Fabrication: A Practical Guide to Semiconductor Processing", Third Edition, by Peter van Zant, McGraw Hill Publishing Co., 1997, ISBN 0-07-067250-4, incorporated herein by reference.

For the sake of simplicity, the projection system may hereinafter be referred to as the "lens"; however, this term should be broadly interpreted as encompassing various types of projection system, including refractive optics, reflective optics, and catadioptric systems, for example. The radiation system may also include components operating according to any of these design types for directing, shaping or controlling the projection beam of radiation, and such components may also be referred to below, collectively or singularly, as a "lens". Further, the lithographic apparatus may be of a type having two or more substrate tables (and/or two or more mask tables). In such "multiple stage" devices the additional tables may be used in parallel, or preparatory steps may be carried out on one or more tables while one or more other tables are being used for exposures. Twin stage lithographic apparatus are described, for example, in US 5,969,441 and WO 98/40791, incorporated herein by reference.

In lithography it is important to accurately project the patterned beam onto a target portion of the substrate. As said, the patterned beam is obtained by imaging the incoming projection beam through a pattern on the mask. One of the problems that may occur during said imaging is fading. Fading is characterized by a low contrast of boundaries of features projected from the mask onto the substrate, which low contrast results from vibrational movement of the projection lens in particular relative to the mask. These vibrational movements are caused by resonances in the lithographic projection apparatus, e.g. eigenfreqencies of the projection lens or some other element in the apparatus, acoustics introduced by gas supplies, or movement of the mask or substrate table. All the different contributions to the vibrational movement of the projection lens result in a complex array of movements which all contribute to the above described fading problem.

It is an object of the present invention to provide a lithographic apparatus capable of reducing the vibrational movements of the projection lens.

This and other objects are achieved according to the invention in a lithographic apparatus as specified in the opening paragraph, characterized by:

   detection means for detecting movement of the projection system and generating a movement signal;
   control means responsive to the movement signal and generating a control signal; and
   actuation means responsive to the control signal for reducing movement of the projection system.

The inventors discovered that vibrational movements with frequencies between 50 and 110 Hz largely contribute to fading. In cooperation the detection and control means the actuation means are capable of actively damping the said vibrational movements of the projection lens, thereby decreasing the characteristics of fading. This is achieved by detecting the vibrational movement of the projection lens with detection means. The detection means generates a movement signal to which the control means is responsive. The control means in turn generates in a feedback loop a control signal. The actuation means responds to the control signal and actively damps the vibrational movements of the lens. In this way, the accuracy with which features of the mask pattern are projected onto a target portion of the substrate is increased as well as the contrast of boundaries of projected features on the substrate.

Preferably the control means generates the control signal using an algorithm based on the H infinity method hereafter referred to as the H∞ method. The H∞ method, which will be further explained below, provides a good damping performance and a high robustness.

Although specific reference may be made in this text to the use of the apparatus according to the invention in the manufacture of ICs, it should be explicitly understood that such an apparatus has many other possible applications. For example, it may be employed in the manufacture of integrated optical systems, guidance and detection patterns for magnetic domain memories, liquid-crystal display panels, thin-film magnetic heads, etc. The skilled artisan will appreciate that, in the context of such alternative applications, any use of the terms "reticle", "wafer" or "die" in this text should be considered as being replaced by the more general terms "mask", "substrate" and "target portion", respectively.

In the present document, the terms "radiation" and "beam" are used to encompass all types of electromagnetic radiation, including ultraviolet radiation (*e.g.* with a wavelength of 365, 248, 193, 157 or 126 nm) and EUV (extreme ultra-violet radiation, *e.g.* having a wavelength in the range 5-20 nm), as well as particle beams, such as ion beams or electron beams.

Embodiments of the invention will now be described, by way of example only, with reference to the accompanying schematic drawings in which:

Figure 1 depicts a lithographic projection apparatus according to an embodiment of the invention;
Figure 2 depicts a first control loop according to the invention;
Figure 3 depicts a second control loop according to the invention;
Figure 4 depicts an additive model error plot according to the invention;
Figure 5 depicts a T border plot according to the invention;
Figure 6 depicts two weighting filters plot according to the invention;
Figure 7 depicts sensitivity border plot according to the invention;
Figure 8 depicts four controller plots according to the invention;
Figure 9 depicts four sensitivity plots according to the invention;
Figure 10 depicts two cumulative PSD plots according to the invention;
Figure 11 depicts two plots of lenstop disturbance and $V_d$-fits according to the invention;
Figure 12 depicts a third control loop according to the invention;
Figure 13 depicts an alternative notation of the third control loop according to the invention;
Figure 14 depicts a multiplicative uncertainty loop according to the invention;
Figure 15 depicts two total performance trade-off plots according to the invention;
Figure 16 depicts two weighting filters plot according to the invention;
Figure 17 depicts a multiplicative model error plot according to the invention;
Figure 18 depicts a modeled Nyquist plot according to the invention;
Figure 19 depicts a measured Nyquist plot according to the invention;
Figure 20 depicts a fourth control loop according to the invention;
Figure 21 depicts two weighting filters plot according to the invention;
Figure 22 depicts two sensitivity plots according to the invention;
Figure 23 depicts two sensitivity plots according to the invention;
Figure 24 depicts four controller plots according to the invention;
Figure 25 depicts four sensitivity plots according to the invention;
Figure 26 depicts four complementary sensitivity plots according to the invention;
Figure 27 depicts four process sensitivity plots according to the invention;
Figure 28 depicts a modeled Nyquist plot according to the invention;
Figure 29 depicts a measured Nyquist plot according to the invention;
Figure 30 depicts two simulated cumulative PSD plots according to the invention.

In the Figures, corresponding reference symbols indicate corresponding parts.

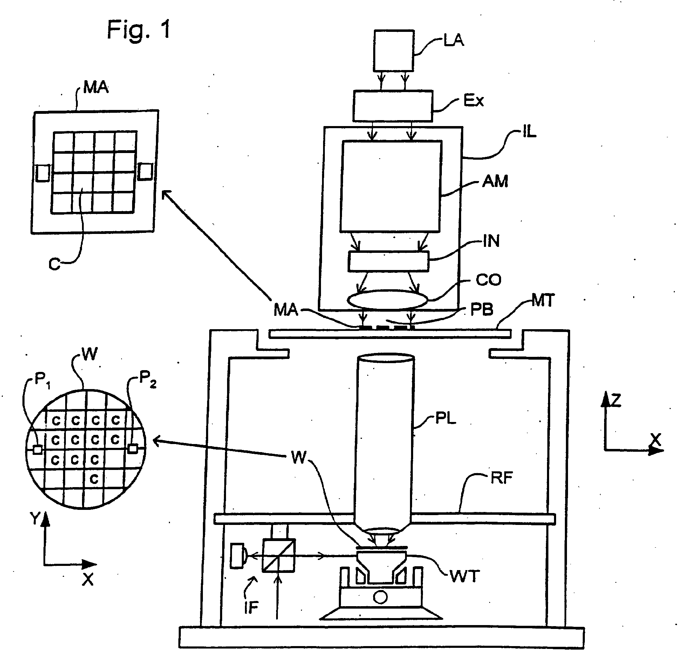

Figure 1 schematically depicts a lithographic projection apparatus according to a particular embodiment of the invention. The apparatus comprises:

a radiation system Ex, IL, for supplying a projection beam PB of radiation (*e.g.* ultraviolet (UV) or extreme ultraviolet (EUV) radiation). In this particular case, the radiation system also comprises a radiation source LA;
a first object table (mask table) MT provided with a mask holder for holding a mask MA (*e.g.* a reticle), and connected to first positioning means for accurately positioning the mask with respect to item PL;
a second object table (substrate table) WT provided with a substrate holder for holding a substrate W (*e.g.* a resist-coated silicon wafer), and connected to second positioning means for accurately positioning the substrate with respect to item PL;
a projection system ("lens") PL (*e.g.* refractive, reflective or catadioptric lens elements) for imaging an irradiated portion of the mask MA onto a target portion C (*e.g.* comprising one or more dies) of the substrate W.

As here depicted, the apparatus is of a transmissive type (*i.e.* has a transmissive mask). However, in general, it may also be of a reflective type, for example (with a reflective mask). Alternatively, the apparatus may employ another kind of patterning means, such as a programmable mirror array of a type as referred to above.

The source LA (*e.g.* Hg lamp, an excimer laser, a plasma-produced laser source) produces a beam of radiation. This beam is fed into an illumination system (illuminator) IL, either directly or after having traversed conditioning means, such as a beam expander Ex, for example. The illuminator IL may comprise adjusting means AM for setting the outer and/or inner radial extent (commonly referred to as σ-outer and σ-inner, respectively) of the intensity distribution in the beam. In addition, it will generally comprise various other components, such as an integrator IN and a condenser CO. In this way, the beam PB impinging on the mask MA has a desired uniformity and intensity distribution in its cross-section.

It should be noted with regard to Figure 1 that the source LA may be within the housing of the lithographic projection apparatus (as is often the case when the source LA is a mercury lamp, for example), but that it may also be remote from the lithographic projection apparatus, the radiation beam which it produces being led into the apparatus (e.g. with the aid of suitable directing mirrors); this latter scenario is often the case when the source LA is an excimer laser. The current invention and Claims encompass both of these scenarios.

The beam PB subsequently intercepts the mask MA, which is held on a mask table MT. Having traversed the mask MA, the beam PB passes through the lens PL, which focuses the beam PB onto a target portion C of the substrate W. With the aid of the second positioning means (and interferometric measuring means IF), the substrate table WT can be moved accurately, *e.g.* so as to position different target portions C in the path of the beam PB. Similarly, the first positioning means can be used to accurately position the mask MA with respect to the path of the beam PB, *e.g.* after mechanical retrieval of the mask MA from a mask library, or during a scan. In general, movement of the object tables MT, WT will be realized with the aid of a long-stroke module (course positioning) and a short-stroke module (fine positioning), which are not explicitly depicted in Figure 1. However, in the case of a wafer stepper (as opposed to a step-and-scan apparatus) the mask table MT may just be connected to a short stroke actuator, or may be fixed.

The depicted apparatus can be used in two different modes:

1. In step mode, the mask table MT is kept essentially stationary, and an entire mask image is projected in one go (*i.e.* a single "flash") onto a target portion C. The substrate table WT is then shifted in the x and/or y directions so that a different target portion C can be irradiated by the beam PB;

2. In scan mode, essentially the same scenario applies, except that a given target portion C is not exposed in a single "flash". Instead, the mask table MT is movable in a given direction (the so-called "scan direction", *e.g.* the y direction) with a speed $v$, so that the projection beam PB is caused to scan over a mask image; concurrently, the substrate table WT is simultaneously moved in the same or opposite direction at a speed $V= Mv$, in which $M$ is the magnification of the lens PL (typically, $M = 1/4$ or $1/5$). In this manner, a relatively large target portion C can be exposed, without having to compromise on resolution.

The projection lens PL is mounted on a reference frame RF or main plate, whereby the vibrational movement of the lenstop of the lens PL (which is closest to the mask table MT) is not easy to control as the distance of the lenstop with respect to the reference frame RF may be relatively large e.g. 1 meter. According to the invention detection means, control means and actuation means are provided to compensate the vibrational movement of the lens PL. The detection means measure the vibrational movement and may be connected to the lens PL, e.g. at the top of the lens PL. Such detection means may be embodied as acceleration measuring devices such as accelerometers, with velocity measuring devices, e.g. geophones, or with displacement measuring devices like piezo-based devices. In the embodiments described below, the lenstop vibrational movement is determined by using two accelerometers capable of measuring accelerations in two orthogonal directions i.e. the X and Y direction. In a step-and-scan apparatus, the Y-direction generally coincides with the scanning direction. After measuring accelerations in the X- and Y-direction, the accelerometers generate a movement signal to which a control means (hereafter referred to as a controller) is responsive. The controller, in turn, will generate a control signal to which the actuation means is responsive. The said actuation means reduces the vibrational movements of the lens PL. An example of such an actuation means or actuator is an air mount (not depicted) connected to the reference frame. Example of such pneumatic air mounts can be gleaned from European Patent Publication 0973067, which is incorporated herein by reference. The air mount may also comprise actuators based on magnetic principles such as a Lorentz-force motor, for example. Alternatively, the actuator may be positioned between the projection lens PL and the reference frame RF. This actuator is capable of moving the projection lens relative to the frame RF and may comprise piezo elements. An example of such an actuator can be gleaned from co-pending unpublished European Patent Application 01300479.1, which is incorporated herein by reference.

In the following, some examples of controllers will be described in more detail. As in a step-and-scan apparatus movement of the mask and/or substrate table may contribute largely to the vibrational movement of the lenstop, the below embodiments particularly describe the vibrational movements in a step-and-scan apparatus. However, the invention is not limited to the step-and-scan apparatus as it can also be applied to a wafer stepper, for example.

A controller is developed for damping of lenstop vibrations, which employs the H∞ control design method. General information about the H∞ method can be gleaned from a publicly available manuscript by A.A.H. Damen and S. Weiland ('Robust Control', Eindhoven University of technology, 1999), which is incorporated herein by reference. Some important aspects of the H∞ design method concerning the use of the method for the problem of damping lenstop acceleration are pointed out here:

- The H∞ design method is well capable to handle MIMO (multiple input multiple output) systems as well as SISO (single input single output) systems;
- The H∞ design method is frequency oriented. This is a great advantage as all the required information is available in the frequency domain;
- The H∞ design method can guarantee robustness.

The critical part of H∞ design is to determine an augmented plant comprising a weighted filter. After choosing initial filters some tuning is needed to obtain the preferable performance. For the choice which weighting filters will be used two aspects must be taken into account:

- Performance;
- Model uncertainty.

Sensor noise is neglected again and no direct penalty will be put on actuation. Furthermore there is no reference signal present, there is only disturbance that has to be damped.

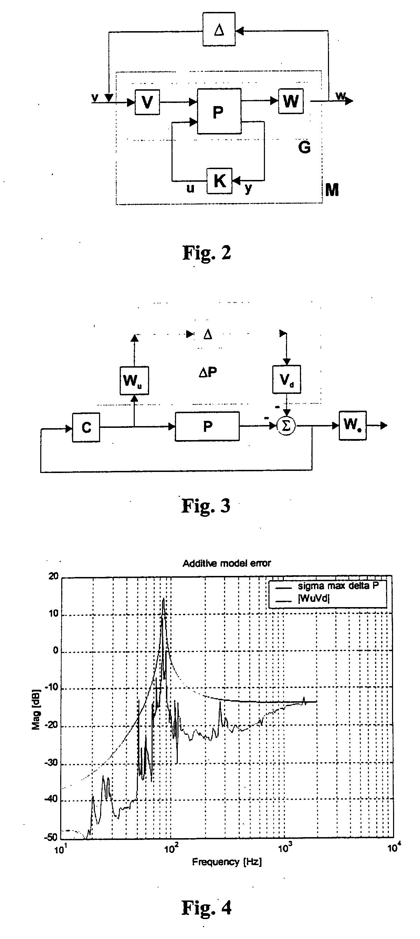

There are three augmented plant setups, resulting from three different control structures, i.e. three different weighting filter combinations, that will be discussed. The standard control system set-up can be seen in figure 2. In this figure P denotes the physical standard plant, G is the generalized standard plant including the weighting filters V and W to specify performance, and M is the augmented plant, the weighted closed-loop system. Each different augmented plant setup results in a different minimizing problem. The weighting filters generally comprise two parts: a scaling filter and a weighting filter for loopshaping. Different scaling for the inputs and outputs can be omitted. This is a consequence of the mutual similarity of the actuators and sensors. Furthermore, the mutual similarity of the sensors and actuators together with equal performance demands for the X and Y direction of the controlled system, result in the use of diagonal weighting filters. So, with every mentioned filter, a [2,2] transfer function matrix is meant, with the filter on the (1,1) and (2,2) position (the other elements of the matrix are zero), unless stated otherwise. Another remark is that phase data of filters will not be plotted, because the H∞ method is phase independent.

It is preferable to keep the composed matrix, resulting from the augmented plant, as small as possible. Therefore a filter $W_u$ on the actuation signal is employed to account for model uncertainty. This is possible, because the filter is not used for restricting actuation. In combination with a disturbance input filter $V_d$, the model uncertainty $\Delta P$ can be modeled. The above-described control structure with the weighting filters is shown in figure 3.

The filter $W_e$ is the filter that penalizes the output signal and thus specifies performance requirements.

With the setup of the augmented plant from figure 3 the H∞ design control method results in the so-called mixed sensitivity problem, the design of a controller that minimizes:

$$\|M\|_\infty = \left\| \begin{pmatrix} W_e S V_d \\ W_u R V_d \end{pmatrix} \right\|_\infty$$

$$W_{et} \cdot S \cdot V_{dt} = \begin{bmatrix} W_e & 0 \\ 0 & W_e \end{bmatrix} \cdot \begin{bmatrix} S_{11} & S_{12} \\ S_{21} & S_{22} \end{bmatrix} \cdot \begin{bmatrix} V_d & 0 \\ 0 & V_d \end{bmatrix} \Rightarrow$$

$$\overline{\sigma}(W_{et} \cdot S \cdot V_{dt}) < \gamma \Leftrightarrow |W_e| \cdot \overline{\sigma}(S) \cdot |V_d| < \gamma \Leftrightarrow \overline{\sigma}(S) < \frac{\gamma}{|W_e V_d|}$$

*equivalently*:

$$\left. \begin{array}{l} \overline{\sigma}(W_{ut} \cdot R \cdot V_{dt}) < \gamma \Leftrightarrow |W_u| \cdot \overline{\sigma}(R) \cdot |V_d| < \gamma \Leftrightarrow |W_u| \cdot \overline{\sigma}(P^{-1}T) \cdot |V_d| < \gamma \\ \overline{\sigma}(P^{-1}T) \geq \underline{\sigma}(P^{-1}) \cdot \overline{\sigma}(T) \end{array} \right\} \Rightarrow$$

$$|W_u| \cdot \underline{\sigma}(P^{-1}) \cdot \overline{\sigma}(T) \cdot |V_d| < \gamma \Leftrightarrow \overline{\sigma}(T) < \frac{\gamma}{|W_u V_d| \cdot \underline{\sigma}(P^{-1})} \Leftrightarrow \overline{\sigma}(T) < \frac{\gamma \cdot \overline{\sigma}(P)}{|W_u V_d|}$$

It holds that:

Preferably $\|M\|_\infty < \gamma \approx 1$, which consequently in the mixed sensitivity problem leads to the following restrictions in the mixed sensitivity problem:

$$\forall \omega : \bar{\sigma}(S) < \frac{1}{|W_e V_d|}$$

$$\forall \omega : \bar{\sigma}(T) < \frac{\bar{\sigma}(P)}{|W_u V_d|}$$

These restrictions can easily be plotted and bottlenecks can easily be recognized, which helps with the choice of weighting filters.

Model uncertainty can best be modeled as additive model uncertainty when using the control structure of figure 3. In this case as a result of the small gain theorem robust stability is guaranteed if:

$$\|M\|_\infty < \gamma \approx 1 \text{ and } \forall \omega : \sigma(\Delta P) < |W_u V_p|$$

wherein $\Delta P$ represents the additive model error. In this case the filter $V_d$ is represented by $V_p$.

It is a great problem to guarantee robustness for damping lenstop acceleration as there exists a harsh trade-off between robustness and performance. Figure 4 shows the maximum singular values of the additive model error This was obtained by subtracting the modeled frequency response functions from the measured frequency response functions. Figure 4 also shows a possible combination $|W_u V_d|$ where applies:

$$\forall \omega : \bar{\sigma}(\Delta P) < |W_u V_p|$$

To guarantee robust stability, the goal was $\|M\|_\infty < \gamma \approx 1$, which was shown to imply:

$$\forall \omega : \bar{\sigma}(T) < \frac{\bar{\sigma}(P)}{|W_u V_d|}$$

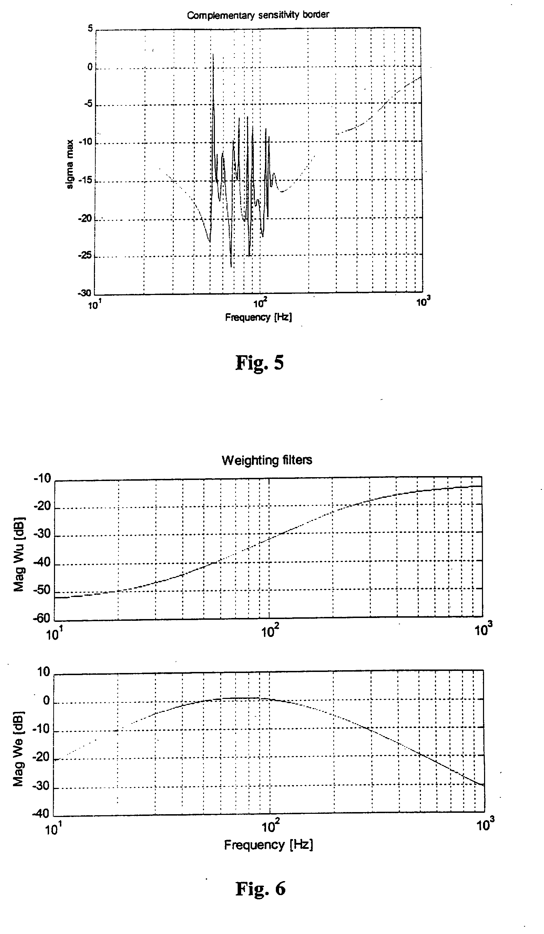

Figure 5 shows the border for the maximum singular value of T when $|W_u V_d|$ is chosen as drawn in figure 4. It can be seen that the border in the bode magnitude plot for this value T is very low, so T has to have a very small value at all frequencies to guarantee robust stability. Because of the rule S+T =I, I will approximately have the size of S, which means that a controller designed in this way will lead to near zero performance improvement. The design and simulation of a controller with the mentioned weighting filters $W_u$ and $V_d$ confirmed this.

As a consequence of the mentioned problem, we have to leave out the guarantee for robust performance. This does not have to be disastrous, because the restriction that the H∞ method lays on the controller design to guarantee robustness often is far more stringent than needed. Therefore the only restriction left will be the performance of the designed controller. The filter $W_u$ is employed to restrict R, but far above the robustness requirement.

A first tuned H∞ controller was developed with the disturbance taken as white noise, where $V_d$ =1. The filters $W_e$ and $W_u$ are plotted in figure 6 and the transfer functions are:

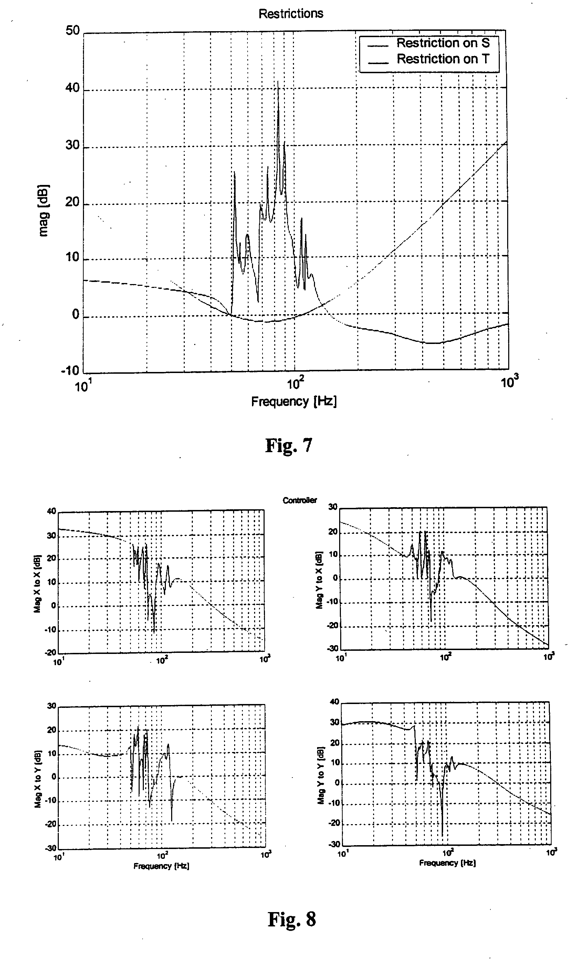

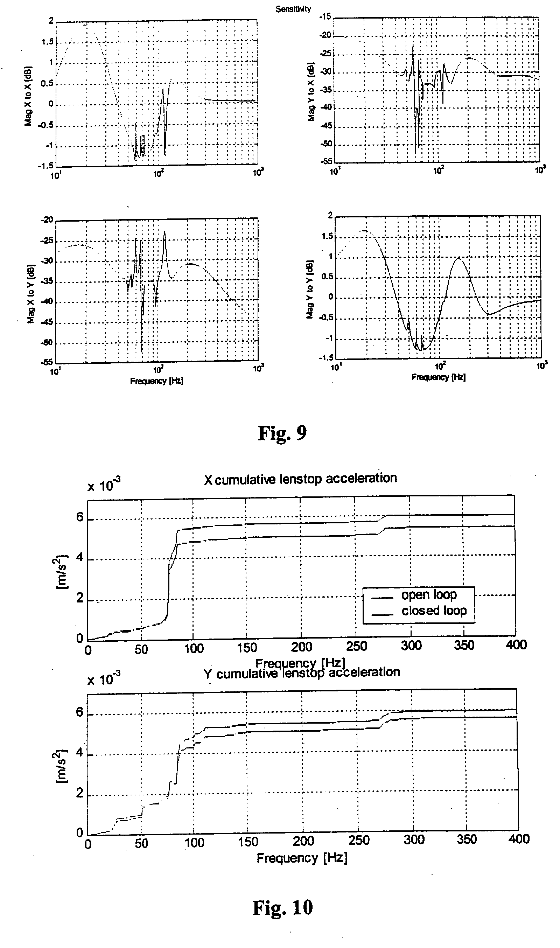

$W_u$ was chosen to follow the shape of the model uncertainty in the frequency domain, except for the peak. $W_e$ was chosen to emphasize the performance requirement in the area 50-110 Hz. The restrictions imposed on S and T by these filters can be seen in figure 7. Figure 8 shows the controller that emerged from this design. The achieved $\gamma$-value was 1.11. It can be seen that the controller actions are quite low. The sensitivity plot, figure 9 shows that the controller indeed emphasizes to improve the performance in the area 50-110 Hz. However, because white noise was taken as input for the disturbance input filter $V_d$, there is no extra emphasis in suppressing certain resonance frequencies. So, the controller wants to improve the performance over a wide area and because of the explained strong trade-off between performance improvement and deterioration, the obtained performance improvement is very minimal. Furthermore the required sensitivity decrease at the non-minimum phase zero locations can not be complied with.

This controller was the best controller obtained with the filter $V_d$ = 1. It will not be analyzed further, because of its very minimal performance (9% respectively 8% RMS improvement for X and Y (RMS is the root mean square value of the measured lesntop

$$We = 2.9 \cdot 10^{-4} \cdot \left( \frac{(s + 2 \cdot \pi \cdot f_{e1})^2 \cdot (s + 2 \cdot \pi \cdot f_{e2})^2}{(s + 2 \cdot \pi \cdot f_{e3})^2 \cdot (s + 2 \cdot \pi \cdot f_{e4})^2} \right)$$

$$Wu = 0.23 \cdot \left( \frac{(s + 2 \cdot \pi \cdot f_{u1})^2}{(s + 2 \cdot \pi \cdot f_{u3})^2} \right)$$

$$f_{e1} = 1 Hz,\ f_{e2} = 1 \cdot 10^4 HZ,\ f_{e3} = 50 HZ,\ .f_{e4} = 110 Hz$$

$$f_{u1} = 30 Hz,\ f_{u2} = 300 Hz$$

acceleration), which can also be seen in the cumulative PSD plot resulting from a simulation in figure 10 (where a PSD plot is power spectrum density plot of the measured lenstop acceleration). Anyway, also with this filter shape choice, a trade-off between the performance inside and outside the 50-110 Hz area was possible, again a conservative approach was taken. Furthermore, the performance improvement fluctuates little over the tracefiles, because of the lack of sharp peaks and narrow drops in the sensitivity.

The best way to precisely model the disturbance with a filter, is to fit a filter exactly over the PSD of the measured disturbance data. First phase data has to be generated, because only magnitude data are available in a PSD function.

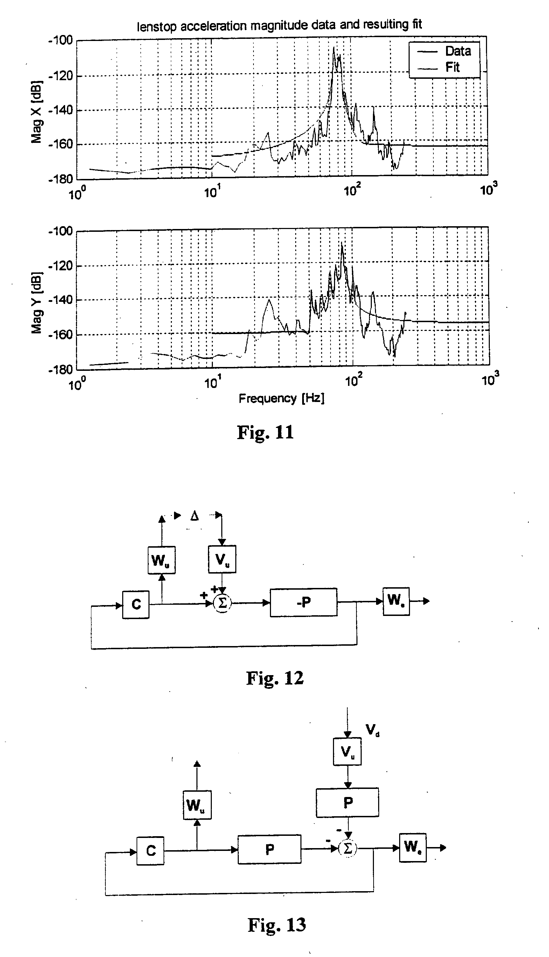

An important remark at this point is that H∞ design (before possible order reduction) leads to a controller that is of the order of the process (40 in this case) plus the order of all the filters. Consequently, a higher order fit on the disturbance PSD-s, will lead to a higher order controller. This is a reason to confine the fit to a few orders. Furthermore this filter will not be diagonal, because the disturbance PSD in x-direction differs from the disturbance PSD in y direction. Fits can be seen in figure 11, $V_{dx}$ was 6th order and $V_{dy}$ was 12th order.

There was no success in designing a usable controller in this way. γ-values exceeded 100, almost all the time, also with the most conservative controller design, i.e. very low performance weights. The reason for this appears to be numerical. When the 6th order $V_{dx}$ and the 12th order $V_{dy}$ filter are used, the function hinfsyn is not capable of calculating controllers with a γ-value below 1000, regardless of the $W_e$ and $W_u$ filters, even when the restrictions on performance are very low. Decreasing $W_e$ and $W_u$ does not reduce the obtained γ-value. When the order of the $V_d$ filters is reduced, the γ-value that can be obtained does decrease. However, keeping $V_d$ of the order that is needed to approximate the disturbance-PSD-s very roughly, did never lead to a γ-value near 1 and a well performing controller.

An alternative augmented plant will be described in the following. This plant will take the disturbance information into account. In doing so, it is preferable to prevent the use of high order filters. This can be done by composing the augmented plant as depicted in figure 12. It can be seen that the $V_d$ filter is left out and that an actuation input filter $V_u$ has come in its place. The augmented plant now can be compared with the plant that is depicted in figure 13.

When the filter $V_u$ is taken as a constant value, the disturbance is shaped with the great difference that a high order filter is not needed. The disadvantage of the new configuration is that although the disturbance has much resemblance with the process, it is not the same. Therefore the disturbance are not modeled exactly and this approach will especially optimize the decrease of the process sensitivity P*S.

The H∞ optimization problem again becomes a kind of mixed sensitivity problem and will minimize:

$$\|M\|_\infty = \left\| \begin{pmatrix} W_e P \cdot S V_u \\ W_u T V_u \end{pmatrix} \right\|_\infty$$

The $V_u$ filter will be taken simply I. Design restrictions will only be applied with the other two filters, $W_u$ and $W_e$. Restrictions on T and S can be deducted equivalently to the deduction of the restrictions at the previous augmented plant setup and when aimed at $\|M\|_\infty < \gamma \approx 1$, they become:

$$\forall\omega:\bar{\sigma}(S)<\frac{1}{|W_eV_u|\underline{\sigma}(P)}$$

$$\forall\omega:\bar{\sigma}(T)<\frac{1}{|W_uV_u|}$$

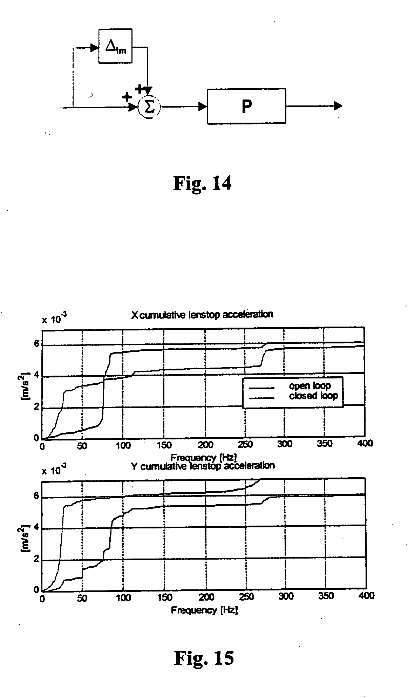

$W_u$ will be used to model the model uncertainty. But because of the different structure of the augmented plant, it needs to be reviewed how this has to be done. The modeling of the uncertainty can better be done with input multiplicative model uncertainty, depicted in figure 14.
As a result of the small gain theorem robust stability is assured when:

$$\forall\omega:\ \bar{\sigma}(T)\cdot\bar{\sigma}(\Delta_{im})<1 \Leftrightarrow \forall\omega:\bar{\sigma}(W_uTV_u\cdot\frac{1}{|W_uV_u|})\cdot\bar{\sigma}(\Delta_{im})<1$$

And because:

$$\|M\|_\infty <\gamma \approx 1 \Rightarrow \|W_uTV_u\|_\infty <1 \Leftrightarrow \forall\omega:\bar{\sigma}(W_uTV_u)<1 \Rightarrow$$

$$\bar{\sigma}(W_uTV_u\cdot\frac{1}{W_uV_u})\leq\bar{\sigma}(W_uTV_u)\cdot\frac{1}{|W_uV_u|}<\frac{1}{|W_uV_u|}$$

A sufficient condition for robust stability is:

$$\frac{1}{|W_uV_u|}\bar{\sigma}(\Delta_{im}) < 1 \Leftrightarrow \bar{\sigma}(\Delta_{im}) <|W_uV_u|$$

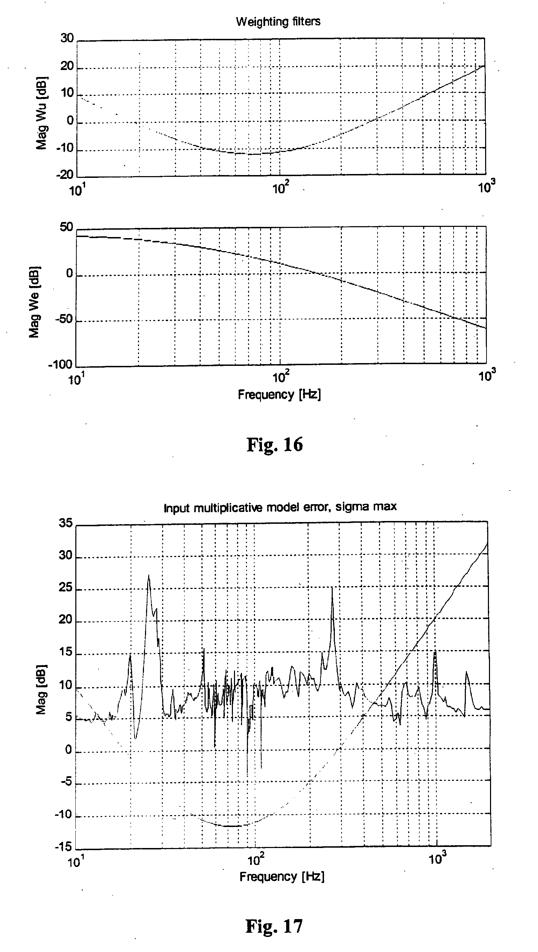

The weighting filters can be chosen so that $|W_uV_u|$ meets this condition. So, we can use $W_u$ to model model uncertainty and guarantee robust stability, however again it will not be possible to reach this guarantee when also requiring performance.
This configuration of the augmented plant turned out to be very convenient to work with. The performance of the controllers designed in this way was often acceptable. A total trade-off was possible between the performance inside and outside the 50-110 Hz frequency area.
Figure 15 shows what is meant with this total trade-off. In this figure the cumulative PSD-s resulting from a simulation that was calculated to obtain a controller that performed very well in the area 50-110 Hz. It can be seen that this happens at the cost of frequencies outside this area.
After tuning the controller the best performance requirements were obtained with the filters denoted below and plotted in figure 16.

$$We = 8.38\cdot10^{-8}\cdot\left(\frac{(s+2\cdot\pi\cdot f_{e1})^4}{(s+2\cdot\pi\cdot f_{e2})^2\cdot(s+2\cdot\pi\cdot f_{e3})^2}\right)$$

$$Wu = 1000\cdot\left(\frac{(s+2\cdot\pi\cdot f_{u1})^2\cdot(s+2\cdot\pi\cdot f_{u2})^2}{(s+2\cdot\pi\cdot f_{u3})^2\cdot(s+2\cdot\pi\cdot f_{u4})^2}\right)$$

$$f_{e1} =1\cdot10^4\ Hz,\ f_{e2} = 20Hz,\ f_{e3} =110Hz$$

$$f_{u1} = 50Hz,\ f_{u2} =110Hz,\ f_{u3} = 1Hz,\ f_{u4} =10000Hz$$

The mean performance improvement concerning RMS-values with this controller was 46 % in X direction and 24 % in Y-direction, which is rather well compared with previous designed controllers. Again it was not possible to guarantee the robust stability, the input multiplicative model uncertainty was calculated and plotted in figure 17, with the modeled model uncertainty plotted in the same figure.

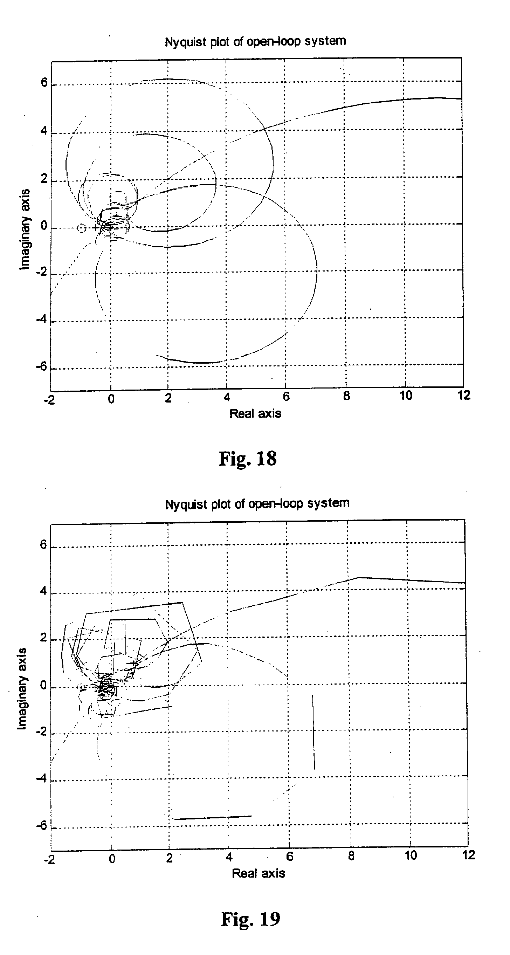

It turned out that, contrary to designed controllers in previous sections, evaluation of this controller with the measured transfer functions lead to an unstable closed-loop. This can be seen in the Nyquist plots in figure 18 and 19. The Nyquist plot of the modeled system does not encircle the point -1, while the plot with the measured system does encircle this point. It was found that the difference between the modeled and the measured system leads to an unstable loop with almost any controller that performed rather well, but that was designed with this augmented plant structure. With other words, omitting the robustness guarantee and designing a controller with the augmented plant structure of figure 12, leads to a controller that is not robust enough. The reason for this is that with the mixed sensitivity problem pole/zero cancellations are likely to occur, which leads to this low robustness. Studying pole-zero maps confirmed that this is the case.

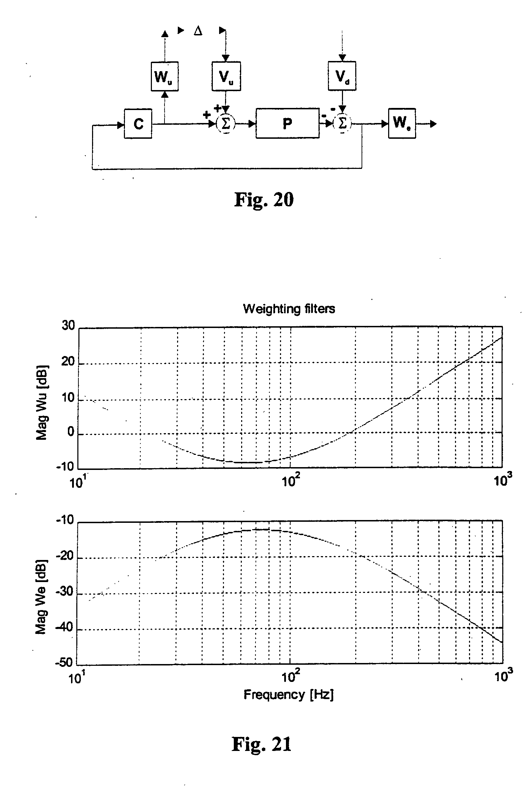

The robustness is improved in a third embodiment which will be described below. At this moment we will leave the principle of keeping the composed matrix M resulting from the augmented plant, as small as possible. Pole/zero cancellations are less likely to occur in the so-called four-block problem and therefore the solution of that problem inherently introduces robustness. This four-block problem is obtained when the two previous proposed augmented plants are combined, i.e. when the augmented plant contains both an actuation input filter and a disturbance input filter. This augmented plant can be seen in figure 20. In the figure it can be seen that the model uncertainty is modeled with input multiplicative uncertainty. The model uncertainty will not be discussed any further.

The four-block problem is to minimize:

$$\|M\|_{\infty} = \left\| \begin{pmatrix} W_e S V_d & W_e P \cdot S V_u \\ W_u R V_d & W_u T V_u \end{pmatrix} \right\|_{\infty}$$

Instead of one restriction on S and one restriction on T, still aiming at $\|M\|_{\infty} < \gamma \approx 1$ leads to two restrictions for S and two for T. This leads to the opportunity to use low order filters to stress performance at certain frequencies while still fairly restricting the sensitivity at other frequencies.

Shaping and tuning of the filters until the optimal performance was reached, lead to the following filters:

$$Vd = 4.54 \cdot 10^{-2}$$

$$Vu = 1$$

$$We = 2.69 \cdot 10^{-3} \cdot \left( \frac{(s + 2 \cdot \pi \cdot f_{e1})^2 (s + 2 \cdot \pi \cdot f_{e2})^2}{(s + 2 \cdot \pi \cdot f_{e3})^2 \cdot (s + 2 \cdot \pi \cdot f_{e4})^2} \right)$$

$$Wu = 2250 \cdot \left( \frac{(s + 2 \cdot \pi \cdot f_{u1})^2 \cdot (s + 2 \cdot \pi \cdot f_{u2})^2}{(s + 2 \cdot \pi \cdot f_{u3})^2 \cdot (s + 2 \cdot \pi \cdot f_{u4})^2} \right)$$

$$f_{e1} = 1\,Hz, f_{e2} = 1 \cdot 10^4\,Hz, f_{e3} = 50\,Hz, f_{e4} = 110\,Hz$$

$$f_{u1} = 60\,Hz, f_{u2} = 70\,Hz, f_{u3} = 1\,Hz, f_{u4} = 10000\,Hz$$

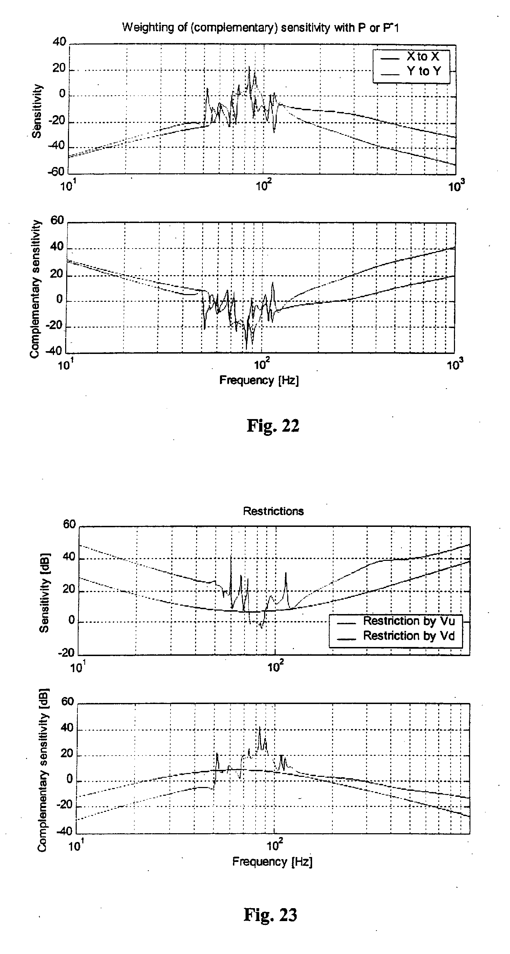

A plot of the filters $W_e$ and $W_u$ can be seen in figure 21. Figure 22 shows the weighting on S and T for the X to X and the Y to Y direction by respectively $|W_e P_i V_u|$ and $|W_u P_i^{-1} V_d|$ where for $P_i$ the values of $P_{11}$ respectively $P_{22}$ were taken. In this way it is possible to see where extra performance improvement is requested for the X to X and Y to Y direction. Figure 23 shows the restrictions that are made on S and T. It can be noticed that although extra performance improvement at resonance frequencies is still required, it is not allowed to comply with this request by too much performance deterioration at other frequencies.

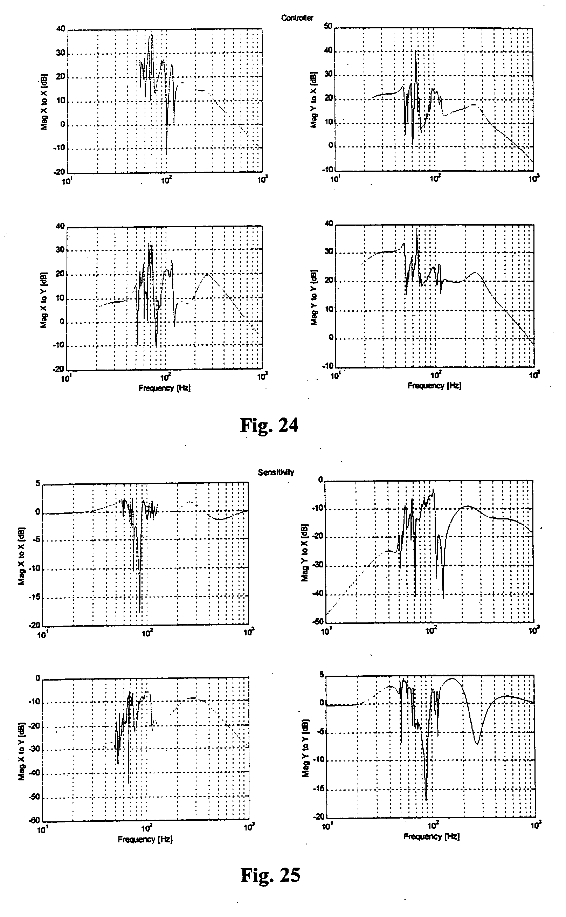

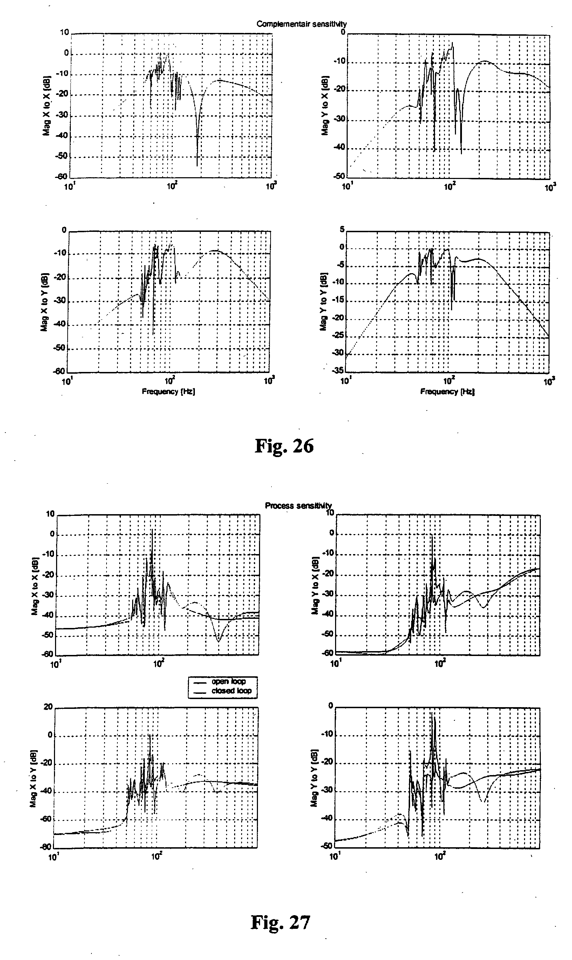

The designed controller can be seen in figure 24, the sensitivity in figure 25, the complementary sensitivity in figure 26 and the process sensitivity in figure 27. The obtained γ-value was 0.98. The complementary sensitivity plot shows that the neglecting of the sensor noise did not lead to an unacceptable complementary sensitivity and therefore was allowed. The actuation signal does not exceed 0.2 V and does not have components below 5 Hz. The process sensitivity plot shows that indeed the controller emphasizes to suppress the resonance peaks.

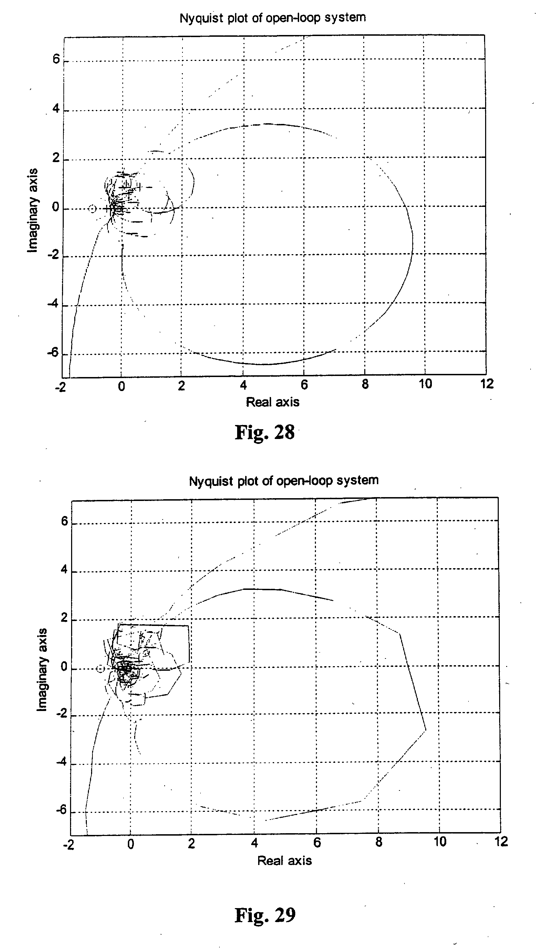

Figure 28 shows the MIMO Nyquist plot of the modeled open-loop, figure 29 shows the Nyquist plot of the measured open-loop. It can be seen that the system indeed is stable. With this augmented plant setup, it was far easier to trade off between robustness and performance.

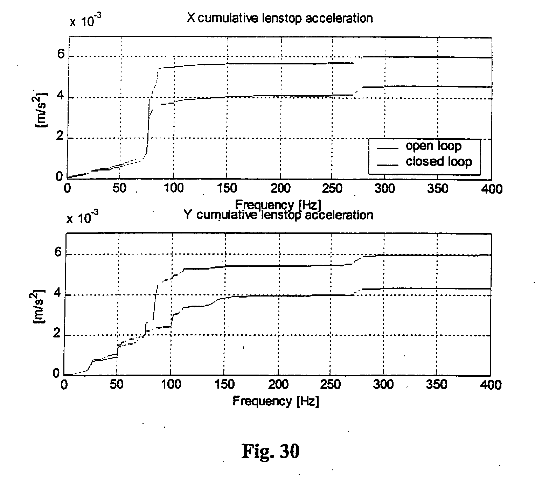

Figure 30 shows the cumulative PSD that results from a simulation with this controller. The mean performance improvement concerning RMS-values obtained with this controller were 32% in x-direction and 33% in y-direction.

Whilst specific embodiments of the invention have been described above, it will be appreciated that the invention may be practiced otherwise than as described. The description is not intended to limit the invention.

### Claims

**1.** A lithographic projection apparatus comprising:

- a radiation system for providing a projection beam of radiation;
- a support structure for supporting patterning means, the patterning means serving to pattern the projection beam according to a desired pattern;
- a substrate table for holding a substrate;
- a projection system mounted on a main plate for projecting the patterned beam onto a target portion of the substrate,

**characterized by**:

detection means for detecting movement of the projection system and generating a movement signal;
control means responsive to said movement signal and generating a control signal; and
actuation means responsive to said control signal for reducing said movement of the projection system.

**2.** An apparatus according to claim 1 **characterized in that** said actuation means are positioned between the projection system and the main plate and are capable of moving said projection system relative to the main plate.

**3.** An apparatus according to claim 2 **characterized in that** the actuation means comprises a piezo element.

**4.** An apparatus according to claim 1 **characterized in that** said actuation means are connected to the main plate.

**5.** An apparatus according to claim 4 **characterized in that** the actuation means is an air mount.

**6.** An apparatus according to any one of the preceding claims **characterized in that** the control means generate the control signal using an algorithm based on a method referred to as H infinity.

Fig. 1

Fig. 2

Fig. 3

Fig. 4

**Fig. 5**

**Fig. 6**

**Fig. 7**

**Fig. 8**

**Fig. 9**

**Fig. 10**

Fig. 11

Fig. 12

Fig. 13

**Fig. 14**

**Fig. 15**

Fig. 16

Fig. 17

Nyquist plot of open-loop system

**Fig. 18**

Nyquist plot of open-loop system

**Fig. 19**

**Fig. 20**

**Fig. 21**

**Fig. 22**

**Fig. 23**

Fig. 24

Fig. 25

**Fig. 26**

**Fig. 27**

Nyquist plot of open-loop system

**Fig. 28**

Nyquist plot of open-loop system

**Fig. 29**

Fig. 30

**European Patent Office**

## EUROPEAN SEARCH REPORT

Application Number

EP 02 25 4550

### DOCUMENTS CONSIDERED TO BE RELEVANT

| Category | Citation of document with indication, where appropriate, of relevant passages | Relevant to claim | CLASSIFICATION OF THE APPLICATION (Int.Cl.7) |
|---|---|---|---|
| X | EP 1 041 607 A (NIPPON KOGAKU KK) 4 October 2000 (2000-10-04) discloses claims 1-4 * paragraph '0030! * * paragraph '0044! * * figure 1 * | 1-6 | G03F7/20 |
| X | US 5 187 519 A (TAKABAYASHI YUKIO ET AL) 16 February 1993 (1993-02-16) discloses claims 1, 2, 4, 5 * column 5, line 51 – column 9, line 68 * * column 6, line 37 – line 44 * * column 7, line 40 – line 45 * * column 9, line 58 – line 61 * * figures 2-5 * | 1-6 | |
| X | DATABASE COMPENDEX 'Online! ENGINEERING INFORMATION, INC., NEW YORK, NY, US; KAJIWARA KOUICHI ET AL: "Large scale active microvibration control system using piezoelectric actuators applied to semiconductor manufacturing equipment" Database accession no. EIX98184106908 XP002186461 * abstract * -& NIPPON KIKAI GAKKAI RONBUNSHU C;NIPPON KIKAI GAKKAI RONBUNSHU, C HEN/TRANSACTIONS OF THE JAPAN SOCIETY OF MECHANICAL ENGINEERS, PART C NOV 1997 JSME, TOKYO, JAPAN, vol. 63, no. 615, November 1997 (1997-11), pages 3735-3742, XP001052657 -/-- | 1-6 | TECHNICAL FIELDS SEARCHED (Int.Cl.7) G03F H01L |

The present search report has been drawn up for all claims

| Place of search | Date of completion of the search | Examiner |
|---|---|---|
| THE HAGUE | 19 August 2002 | Heryet, C |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons
& : member of the same patent family, corresponding document

EPO FORM 1503 03.82 (P04C01)

**European Patent Office**

## EUROPEAN SEARCH REPORT

Application Number

EP 02 25 4550

### DOCUMENTS CONSIDERED TO BE RELEVANT

| Category | Citation of document with indication, where appropriate, of relevant passages | Relevant to claim | CLASSIFICATION OF THE APPLICATION (Int.Cl.7) |
|---|---|---|---|
| X | US 5 726 879 A (SATO MIKIO) 10 March 1998 (1998-03-10) * abstract * * column 16, line 12 - column 17, line 49 * * column 17, line 7 - line 12 * * column 24, line 33 - column 25, line 62 * * column 25, line 31 - line 37 * * figures 1,23 * | 1-6 | |
| X | TSAI K-Y ET AL: "Servo system design of a high-resolution piezo-driven fine stage for step-and-repeat microlithography systems" INDUSTRIAL ELECTRONICS SOCIETY, 1999. IECON '99 PROCEEDINGS. THE 25TH ANNUAL CONFERENCE OF THE IEEE SAN JOSE, CA, USA 29 NOV.-3 DEC. 1999, PISCATAWAY, NJ, USA,IEEE, US, 29 November 1999 (1999-11-29), pages 11-16, XP010366868 ISBN: 0-7803-5735-3 * abstract * * page 13, right-hand column, paragraph 6 * | 1-6 | TECHNICAL FIELDS SEARCHED (Int.Cl.7) |

The present search report has been drawn up for all claims

| Place of search | Date of completion of the search | Examiner |
|---|---|---|
| THE HAGUE | 19 August 2002 | Heryet, C |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

## ANNEX TO THE EUROPEAN SEARCH REPORT
## ON EUROPEAN PATENT APPLICATION NO.

EP 02 25 4550

This annex lists the patent family members relating to the patent documents cited in the above-mentioned European search report.
The members are as contained in the European Patent Office EDP file on
The European Patent Office is in no way liable for these particulars which are merely given for the purpose of information.

19-08-2002

| Patent document cited in search report | | Publication date | Patent family member(s) | | Publication date |
|---|---|---|---|---|---|
| EP 1041607 | A | 04-10-2000 | AU | 1051999 A | 31-05-1999 |
| | | | EP | 1041607 A1 | 04-10-2000 |
| | | | WO | 9925011 A1 | 20-05-1999 |
| US 5187519 | A | 16-02-1993 | JP | 2753893 B2 | 20-05-1998 |
| | | | JP | 4144114 A | 18-05-1992 |
| | | | JP | 2715182 B2 | 18-02-1998 |
| | | | JP | 4143764 A | 18-05-1992 |
| | | | DE | 4133037 A1 | 09-04-1992 |
| | | | GB | 2249189 A ,B | 29-04-1992 |
| US 5726879 | A | 10-03-1998 | JP | 7253804 A | 03-10-1995 |

EPO FORM P0459

For more details about this annex : see Official Journal of the European Patent Office, No. 12/82